# FASCICULE DE BREVET EUROPEEN

(11) **EP 1 156 644 B1**
(45) Date de publication et mention de la délivrance du brevet: **28.05.2003**
(21) Numéro de dépôt: 01400805.6
(22) Date de dépôt: 28.03.2001
(51) Int. Cl.: H04M 1/23, H01H 13/70, H05K 1/14

(54) **Appareil électronique muni d'un clavier simplifié notamment un téléphone mobile**
Elektronisches Gerät mit vereinfachterTastatur, insbesondere eines Mobiltelefons
Electronic device having a simplified keyboard, in particular a mobile phone

(30) Priorité: 29.03.2000 FR 0004370
(43) Date de publication de la demande: 21.11.2001
(73) Titulaire: SAGEM S.A., 75015 Paris (FR)
(72) Inventeur: Romao, M. Fernando, 78360 Montesson (FR)
(74) Mandataire: Schmit, Christian Norbert Marie

(56) Documents cités:
- WO-A-97/29621
- DE-A- 4 307 613
- DE-U- 9 421 742
- US-A- 5 986 342

## Description

L'invention a pour objet un appareil électronique muni d'un clavier simplifié notamment un téléphone mobile. Le but de l'invention est de réduire des coûts de production, des coûts de mise en place et une simplification de la production, notamment pour ces téléphones mobiles. De tels claviers simplifiés peuvent être utilisés dans le domaine de la téléphonie mobile mais aussi pour des calculatrices, des agendas électroniques ou tout autre appareil disposant d'un clavier de commande.

Un clavier de commande est un ensemble à part entière qui doit être relié à un circuit imprimé principal. Il existe différentes solutions pour relier un clavier au circuit imprimé principal.

Une première solution pour réaliser le clavier est d'utiliser un flex assurant en plus une fonction de matrice de détecteurs du clavier, et de relier ce flex au circuit imprimé principal par un connecteur. Un flex est une nappe isolante flexible munie de pistes conductrices (en général gravées). Un flex peut ainsi porter des circuits élémentaires intégrés électroniques, des circuits élémentaires hybrides ou des connexions mises en forme. Ces circuits élémentaires remplissent chacun une fonction de détecteur électronique. Un tel flex assure alors les différentes fonctions du clavier. Cependant une telle solution coûte cher et prend de la place. En effet, un flex coûte plus cher qu'un circuit imprimé, son procédé de fabrication est délicat, et un double connecteur est nécessaire : un premier connecteur raccordé au flex, et un deuxième connecteur, complémentaire du premier, raccordé au circuit imprimé principal.

Une deuxième solution pour réaliser le clavier est d'utiliser un circuit imprimé supplémentaire que l'on connecte à l'aide d'un double connecteur au circuit imprimé principal. Cette solution présente l'avantage d'éliminer le coût du flex, mais présente l'inconvénient d'utiliser un double connecteur pour relier entre eux les deux circuits imprimés. Un double connecteur est un élément encombrant et qui coûte cher.

Une troisième solution pour réaliser le clavier est de réaliser la matrice des détecteurs du clavier directement sur le circuit imprimé principal. Cette dernière solution est la meilleure des trois en terme de coût, de simplicité et de compacité. Cependant elle induit des contraintes. La matrice des touches du clavier est géographiquement imposée à la surface du circuit principal. En effet, le circuit imprimé principal doit alors comporter des circuits élémentaires à sa surface en regard de ces touches. Ceci crée des difficultés pour gérer des schémas différents d'organisation des touches avec un même circuit imprimé principal. Une telle réalisation conduit en outre à l'impossibilité de faire des vias traversant le circuit imprimé principal dans la zone de contact des touches. Or de tels vias traversants sont particulièrement nécessaires lorsque le circuit imprimé principal est un circuit multicouche (avec plusieurs couches de connexions empilées entre ses faces supérieures et inférieures). Il est possible de réaliser des vias non traversants, notamment par percement au laser, mais les coûts deviennent prohibitifs.

Dans cette troisième solution, la surface externe du circuit imprimé principal offre de plus une mauvaise immunité au rayonnement. En effet, dans un tel cas il n'y a plus de plan de masse intégral qui protège les zones sensibles. Il serait envisageable de réaliser une couche spéciale pour ce plan de masse intégral mais cela rajouterait des coûts supplémentaires et des difficultés de réalisation en plus. Il faut prendre en compte une taille de doigt très importante pour pouvoir gérer des positions des touches du clavier variables dans le temps. Ainsi la diversité des dispositions des touches est faible.

Il serait aussi envisageable d'utiliser un clavier en polyester placé sur le circuit imprimé principal soit uniquement par deux soudures, soit par un dos adhésivé, soit les deux. Le raccordement électrique avec la carte serait effectué soit par un connecteur, soit par un élastomère anisotropique, soit par un zébra, soit par pression mécanique. Une telle solution est complexe à réaliser.

Dans l'invention la matrice du clavier est réalisée sur un circuit imprimé à part. Ce circuit imprimé à part ne comportant que des circuits élémentaires détecteurs correspondant aux touches du clavier, est alors soudé sur le circuit imprimé principal comme un composant. Ce circuit imprimé à part est de préférence reporté sur le circuit imprimé principal par une technologie dite de castellation. Une castellation est une soudure par la tranche. Sur une tranche d'un circuit imprimé à part, des demi-vias latéraux sont réalisés et reliés aux circuits élémentaires de détection. Ces demi-vias sont de plus soudés à des plages conductrices périphériques du circuit imprimé principal. Ces soudures réalisent une fixation du circuit imprimé du clavier au circuit imprimé principal. Ces demi-vias établissent aussi des liens électriques entre les circuits élémentaires de la matrice du clavier et les différentes couches du circuit imprimé principal. On réalise ainsi une soudure d'un circuit imprimé relativement grand et fin sur une carte principale plus épaisse.

Des demi-vias sont plus intéressants que des vias entiers car ils prennent moins de place. Ils sont tout à fait fonctionnels grâce au phénomène de capillarité de la soudure au moment de la soudure. Toutefois, si l'encombrement n'est pas un problème on peut souder le circuit imprimé secondaire au circuit imprimé principal par des vias entiers.

L'invention concerne donc un appareil électronique défini par les caractéristiques de la revendication.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1: une représentation simplifiée d'un circuit imprimé multicouche d'un téléphone mobile selon l'invention ;
- Figure 2 : une représentation schématique du circuit imprimé secondaire ajouté ainsi que ses liaisons avec le circuit principal.

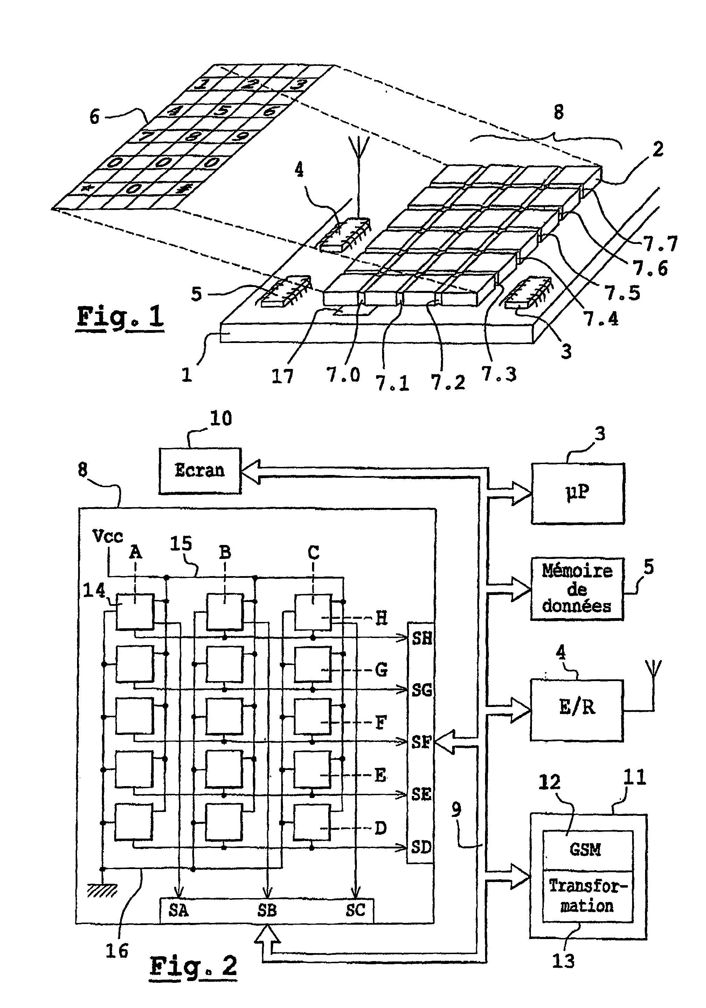

La figure 1 montre un appareil électronique conforme à l'invention. Cet appareil comporte un circuit imprimé principal 1. Le circuit 1 est un circuit multicouche de préférence. Il comporte notamment des vias traversants. Ces vias traversants ne sont pas visibles sur la figure 1 car ils sont masqués par un circuit imprimé 2 rajouté par soudure au-dessus du circuit 1. Ces vias traversants établissent des connexions entre les différentes couches du circuit imprimé principal. Le circuit 1 permet de relier entre eux des composants tels qu'un microprocesseur 3, un émetteur-récepteur 4 et une mémoire de données 5. Les composants 3 à 5 sont montrés ici connectés sur une face du circuit 1. D'autres composants, non visibles ici, peuvent être montés sur une autre face du circuit 1 (celle qui n'est pas visible sur la figure 1). Le circuit 2 porte pour sa part une matrice de touches d'un clavier de commande 6.

Le clavier de commande 6, comportant ici quinze touches réparties sur cinq lignes et trois colonnes, est en regard d'une matrice avec cinq lignes et trois colonnes de détecteurs sur le circuit 2. Les différents détecteurs de la matrice de détecteurs sont chacun situés à l'aplomb d'une touche. Les circuits élémentaires de détection du clavier sont accessibles sur le circuit 2 par des connexions individualisées (électriquement indépendantes) en nombre égal au moins au nombre de lignes et de colonnes. Ces connexions débouchent latéralement sur des trous métallisés, ou vias. De préférence ces trous sont remplacés par des demi-trous, des demi-vias 7.0 à 7.7, par réalisation d'encoches métallisées dans des chants du circuit 2. Des vias entiers sont par exemple d'abord réalisés. Puis ces vias sont coupés pour réaliser les demi-vias 7.0 à 7.7. Dans sa superposition sur le circuit 1, le circuit 2 occupe une place sur ce circuit 1 où ne sont pas déposés des composants tels que 3 à 5. La surface supérieure du circuit 2 (celle qui n'est pas contre le circuit 1) est située par rapport au circuit 1 à une altitude du même ordre que la face supérieure des composants 3 à 5.

Le circuit imprimé 2 du clavier 6 est soudé et est ainsi relié aux différentes couches du circuit principal grâce aux demi-vias 7.0 à 7.7. Il y a au moins autant de demi-vias qu'il existe de lignes et de colonnes. Dans l'exemple montré : plus de huit demi-vias sont nécessaires car la matrice a trois colonnes et cinq lignes.

Le circuit 2 est ici réalisé avec deux couches de métallisation. Une première couche est destinée aux connexions correspondant aux lignes. Une deuxième couche est destinée aux connexions correspondant aux colonnes. De préférence ces deux couches sont réalisées de part et d'autre du circuit imprimé 2.

La figure 2 montre une représentation possible sous la forme d'un bloc 8 de la matrice des circuits élémentaires détecteurs réalisés sur le circuit 2. Cette représentation est une représentation électrique. Le bloc 8 comporte huit sorties. Ces huit sorties sont SA, SB, SC, SD, SE, SF, SG et SH. Chaque sortie correspond à une ligne ou à une colonne. Les sorties SA, SB et SC correspondent respectivement à l'état de colonnes de touches A, B et C. Les sorties SD, SE, SF, SG et SH correspondent respectivement à l'état de lignes de touches D, E, F, G et H. Les sorties SA à SH sont reliées aux demi-vias 7.0 à 7.7 respectivement.

Les sorties du bloc 8 sont reliés par l'intermédiaire du bus 9 à une mémoire de données 5 et à un microprocesseur 3. Le microprocesseur 3 est relié par l'intermédiaire du bus 9 à un écran 10, à un émetteur-récepteur 4 et à une mémoire programme 11 comprenant un sous-programme de téléphonie mobile 12 et un sous-programme 13 de transformation.

Le bloc 8 comporte dans un exemple schématique des circuits détecteurs tels que 14 alimentés par une tension de polarisation Vcc par rapport à la masse, par des connexions 15 et 16 respectivement. Chaque circuit tel que 14 est relié à deux sorties : à une sortie colonne SA ou SB ou SC selon la place de la colonne du circuit dans le bloc 8, et à une sortie SD ou SE ou SF ou SG ou SH selon la place de la ligne du circuit dans le bloc 8.

Les circuits détecteurs, de type connu, forment des commutateurs susceptibles d'imposer un état (par exemple le même) sur leurs deux sorties selon un état enfoncé ou non d'une touche qui les surmonte. Ces commutateurs de type connu peuvent comporter des bascules électroniques sensibles à un état de proximité (par enfoncement de touche) d'une surface équipotentielle (une pastille de métal) ou d'une plaque magnétique. Compte tenu de l'alimentation Vcc et de la masse, le nombre de demi-vias sera supérieur à la somme des sorties.

Sur le plan pratique, les résultats des états logiques des sorties SA à SH sont mémorisés grâce au bus 19 dans la mémoire de données 5. Un état à une des sorties SA à SH signifie que l'utilisateur a sélectionné une touche. Le microprocesseur 3 et les programmes 12 et 13 interprètent ces résultats et savent agir en conséquence, notamment faire correspondre un chiffre à un couple de sorties dont le niveau logique est un, et afficher ce chiffre à l'écran 10.

Dans le cas où on cherche à mieux blinder l'appareil de la figure 1, on peut prévoir de réaliser le circuit 2 en tricouche. Deux couches servent alors pour réaliser les pistes SA à SH et les connexions 15 et 16. Une troisième couche, de préférence sous-jacente est un plan de masse. Dans ce cas, ce plan de masse est recouvert d'une pellicule isolante avant d'être plaqué sur le circuit 1 pour ne pas venir au contact des vias traversants de ce circuit 1. Dans tous les cas, le bloc 8 porté par le circuit imprimé secondaire 2 est relié au bus 9 par des ports (les vias 7.0 à 7.7) isolés les uns des autres. Si pour une raison ou une autre on est amené à changer la signification des touches ou à les intervertir, on n'a pas besoin de changer ni le circuit 1 ni le circuit 2. Seul change le clavier 6. Avec la mémoire 5 il est possible de tenir compte du changement de signification, notamment pour afficher des dessins différents sur l'écran 10.

Pour la soudure des vias ou des demi-vias 7.0 à 7.7, on brase ces derniers sur des plots métallisés tels que 17 en attente sur le circuit 1, en regard de leur position. Les plots tels que 17 sont alors réalisés sur la périphérie du circuit 1. Dans la pratique le circuit imprimé 1 aura une épaisseur de l'ordre d'un millimètre (entre 0,8 et 1 mm), alors que le circuit imprimé 2 (de préférence bicouche seulement) aura une épaisseur moindre, par exemple de 0,4 mm. Le circuit 1 a dans un exemple une taille de 37 mm x 88 mm alors que le circuit 2, plus petit, a une taille de 35 mm x 50 mm. Le circuit 2 est totalement inscrit dans le circuit 1.

## Revendications

1. Appareil électronique comportant un circuit (1) imprimé multicouche principal et un clavier (6), **caractérisé en ce que** le clavier comporte une matrice de clavier (6) et une matrice (8) de circuits élémentaires détecteurs (A-H) placée à l'aplomb de la matrice de clavier, les détecteurs de ladite matrice étant assemblés pour former un circuit imprimé secondaire (2), soudé sur le circuit principal.

2. Appareil selon la revendication 1, **caractérisé en ce qu'**il comporte des demi-vias (7.0-7.7) sur le côté du circuit imprimé secondaire pour connecter, par soudure (17), ce circuit imprimé secondaire au circuit imprimé principal.

3. Appareil selon l'une des revendications 1 et 2, **caractérisé en ce qu'**un état (SA-SH) d'une touche du clavier correspond à un état d'un détecteur (A-H) du circuit imprimé secondaire.

4. Appareil selon l'une des revendications 1 à 3, **caractérisé en ce qu'**il comporte des vias (7.0-7.7) traversant le circuit imprimé principal et situés à l'aplomb des touches du circuit imprimé secondaire pour établir des connexions entre les différentes couches du circuit imprimé principal.

5. Appareil selon l'une des revendications 1 à 4, **caractérisé en ce qu'**il est un téléphone mobile (4).

## Patentansprüche

1. Elektronisches Gerät, umfassend eine Mehrlagenhauptschaltung (1) und eine Tastatur (6), **dadurch gekennzeichnet, dass** die Tastatur eine Tastaturmatrix (6) und eine Matrix (8) von elementaren Detektorschaltungen (A-H) umfasst, die lotrecht zur Tastaturmatrix angeordnet ist, wobei die Detektoren dieser Matrix derart zusammengebaut sind, dass sie eine gedruckte Nebenschaltung (2) bilden, die auf die Hauptschaltung geschweißt ist.

2. Gerät nach Anspruch 1, **dadurch gekennzeichnet, dass** es Halbbrücken (7.0-7.7) auf der Seite der gedruckten Nebenschaltung umfasst, um durch Schweißen (17) diese gedruckte Nebenschaltung an die gedruckte Hauptschaltung anzuschließen.

3. Gerät nach einem der Ansprüche 1 und 2, **dadurch gekennzeichnet, dass** ein Zustand (SA-SH) einer Taste der Tastatur einem Zustand eines Detektors (A-H) der gedruckten Nebenschaltung entspricht.

4. Gerät nach einem der Ansprüche 1 bis 3, **dadurch gekennzeichnet, dass** es Brücken (7.0-7.7) umfasst, die die gedruckte Hauptschaltung überqueren und lotrecht zu den Tasten der gedruckten Nebenschaltung angeordnet sind, um Anschlüsse zwischen den verschiedenen Lagen der gedruckten Hauptschaltung herzustellen.

5. Gerät nach einem der Ansprüche 1 bis 4, **dadurch gekennzeichnet, dass** es ein Mobiltelefon (4) ist.

## Claims

1. An electronic device including a main multilayer printed circuit board (1) and a keypad (6), **characterised in that** the keypad consists of a keypad matrix (6) and a matrix (8) of elementary sensor circuits (A-H) positioned perpendicularly to the keypad matrix, the sensors of said matrix being assembled so as to form a secondary printed circuit board (2) soldered to the main circuit board.

2. The electronic device according to claim 1, **characterised in that** it consists of semi-via holes (7.0-7.7) on the side of the secondary printed circuit board to connect this secondary printed circuit board to the main printed circuit board by a soldered connection (17).

3. The electronic device according to either of claims 1 and 2, **characterised in that** a state (SA-SH) of a keypad key corresponds to a state of a sensor (A-H) of the secondary printed circuit board.

4. The electronic device according to any of claims 1 to 3, **characterised in that** it includes via holes (7.0-7.7) that pass through the main printed circuit board and that are positioned perpendicularly to the keys of the secondary printed circuit board to establish connections between the different layers of the main printed circuit board.

5. The electronic device according to any of claims 1 to 4, **characterised in that** it is a mobile telephone (4).
